Europäisches Patentamt

European Patent Office

Office européen des brevets

(11) Veröffentlichungsnummer: **0 150 326**
A2

# EUROPÄISCHE PATENTANMELDUNG

(21) Anmeldenummer: 84114397.7

(22) Anmeldetag: 28.11.84

(51) Int. Cl.⁴: **H 01 J 37/256,** H 01 J 37/02, G 01 N 23/225

(30) Priorität: 31.01.84 DE 3403254

(43) Veröffentlichungstag der Anmeldung: 07.08.85
Patentblatt 85/32

(84) Benannte Vertragsstaaten: DE FR GB NL

(71) Anmelder: **Siemens Aktiengesellschaft, Berlin und München Wittelsbacherplatz 2, D-8000 München 2 (DE)**

(72) Erfinder: **v. Criegern, Rolf, Dipl.-Phys., Lilienstrasse 27, D-8192 Geretsried (DE)**
Erfinder: **Weitzel, Ingo, Dipl.-Phys., Ahornring 3, D-8028 Taufkirchen (DE)**

(54) Verfahren und Vorrichtung zur Kompensation von Aufladungen bei der Sekundärionen-Massenspektrometrie (SIMS) elektrisch schlecht leitender Proben.

(57) Ein Verfahren zur Kompensation von Aufladungen bei der Sekundärionen-Massenspektrometrie elektrisch schlecht leitender Proben (PR), mit einer Raster-Ionenkanone (IG) und einer Elektronenkanone (EG) soll es gestatten, Sekundärionen-Massenspektren von elektrisch schlecht leitenden Proben (PR) unter besser definierten Bedingungen aufzuzeichnen, als dies bisher üblich war. Der Elektronenstrahl der Elektronenkanone (EG) wird auf ungefähr den gleichen Durchmesser fokussiert wie der Ionenstrahl und trifft auf demselben Punkt der Oberfläche der Probe (PR) auf wie der Ionenstrahl.

EP 0 150 326 A2

0150326

SIEMENS AKTIENGESELLSCHAFT     Unser Zeichen
Berlin und München             VPA 84 P 1058 E

Verfahren und Vorrichtung zur Kompensation von Aufladungen bei der Sekundärionen-Massenspektrometrie (SIMS) elektrisch schlecht leitender Proben.

Die Erfindung betrifft ein Verfahren zur Kompensation von Aufladungen bei der Sekundärionen-Massenspektrometrie (SIMS) elektrisch schlecht leitender Proben nach dem Oberbegriff des Anspruchs 1 und eine Vorrichtung zur Kompensation von Aufladungen bei der Sekundärionen-Massenspektrometrie (SIMS) elektrisch schlecht leitender Proben nach dem Oberbegriff des Anspruchs 6.

Bei der Analysentechnik der Sekundärionen-Massenspektrometrie (SIMS) wird die auf ihre elementare Zusammensetzung hin zu analysierende Probe mit einem Ionenstrahl (z.B. Sauerstoff $O_2^+$, 1 bis 15 keV, 1 nA bis 10 µA) beschossen und dadurch langsam abgetragen (Sputter-Prozeß). Die hierbei von der Probenoberfläche freigesetzten (abgesputterten) Atome und Molekülbruchstücke können, sofern sie elektrisch geladen sind ("Sekundärionen"), in ein Massenspektrometer gelenkt, hier nach ihrem Masse-Ladungs-Verhältnis m/e getrennt und mit Hilfe eines Multipliers oder ähnlichem detektiert und gezählt werden.

Um eine gleichmäßige Abtragung der Proben über die zu analysierende Fläche zu erreichen, wird der Ionenstrahl üblicherweise auf die Probenoberfläche fokussiert und zeilenweise über die abzutragende Fläche auf der Probe gerastert.

Bei Proben ausreichender elektrischer Leitfähigkeit fließt der aus dem Ionenstrahlstrom und den von der Probe emittier-

My 1 Bla

ten geladenen Sekundärteilchenströmen (Sekundärelektronen und Sekundärionen) sich ergebende Probenstrom über den Probenhalter und eine Spannungsquelle zur Erde ab. Mit Hilfe der Spannungsquelle, über die dieser Probenstrom zur Erde abfließt, kann der Probenhalter auf ein zur Untersuchung der Probenoberfläche optimales elektrisches Potential gelegt werden.

Bei Proben schlechter Leitfähigkeit, z.B. bei Isolatoren (Oxide, Nitride, Gläser und so weiter), kann der aus dem Ionenstromstrahlstrom und den von der Probe emittierten geladenen Sekundärteilchenströmen sich ergebende Probenstrom nur über den sehr hohen elektrischen Widerstand der Probe bzw. der Probenoberfläche selbst abfließen. Hierdurch kann es durch Aufladungseffekte auf der vom Ionenstrahl getroffenen Fläche der Probe zu extremen Potentialverschiebungen kommen, die die Emission und/oder die Überführung von Sekundärionen in das Massenspektrometer beeinträchtigen oder gänzlich verhindern können.

Besteht der Ionenstrahl aus positiv geladenen Ionen, so wird die Oberflächenaufladung häufig ebenfalls positiv sein und kann dann prinzipiell durch gleichzeitigen Beschuß mit Elektronen kompensiert werden. Aus dem Stand der Technik ist es bekannt, die Probe mit einem stehenden Elektronenstrahl, der einen relativ großen Brennfleckdurchmesser von etwa einem Millimeter aufweist, zu beschießen. Dadurch ist es zumeist möglich, Sekundärionen-Signale von Isolatoroberflächen zu registrieren.

Dieses bekannte Verfahren zur Kompensation von Aufladungen bei der Sekundärionen-Massenspektrometrie wird jedoch den wachsenden Anforderungen an die Qualität, z.B. an die Reproduzierbarkeit der Meßergebnisse, nicht mehr gerecht. Der Grund hierfür ist darin zu sehen, daß Form und Auftreffpunkt des Ionenstrahles und des Elektronenstrahles zu stark voneinander abweichen. Infolgedessen ist die Elektronenstromdichte an den verschiedenen Autreffpunkten des Ionenstrahles während seines Rasterdurchlaufes nicht konstant, und es wird daher keine einheitliche Kompensation von Aufladungen für die gesamte Sputterfläche auf der Probe erzielt.

Ein weiterer Mangel dieser Vorgehensweise liegt darin, daß an allen Stellen, die zwar vom Elektronenstrahl, momentan jedoch nicht vom Ionenstrahl ,getroffen werden, negative Aufladungen erzeugt werden, deren Feld die Überführung der später vom Ionenstrahl ausgelösten Sekundärionen in das Massenspektrometer beeinträchtigen kann und somit das Meßergebnis verfälscht.

Schließlich kommt noch bei diesem bekannten Verfahren zur Kompensation von Aufladungen bei der Sekundärionen-Massenspektrometrie der Nachteil hinzu, daß durch die an sich unnötige und unerwünschte Elektronenbestrahlung der momentan nicht vom Ionenstrahl getroffenen Zonen auf der Oberfläche der Probe, die mit Hilfe dieses Ionenstrahles gesputtert werden müssen, unerwünschte Probenveränderungseffekte, wie z.B. Diffusion und Desorption, induziert werden können.

Der vorliegenden Erfindung liegt die Aufgabe zugrunde, ein Verfahren und eine Vorrichtung der eingangs genannten Art anzugeben, die es gestatten, Sekundärionen-Massenspektren von elektrisch schlecht leitenden Proben unter besser definierten Bedingungen aufzuzeichnen, als dies bisher möglich ist.

Diese Aufgabe wird erfindungsgemäß durch ein Verfahren nach dem Anspruch 1 und durch eine Vorrichtung nach dem Anspruch

0150326
84 P 1058 E

6 gelöst.

Ausgestaltungen und Vorteile der Erfindung sind in den Unteransprüchen, der Beschreibung und der Zeichnung angegeben.

Ein erfindungsgemäßes Verfahren und eine erfindungsgemäße Anordnung führen zu einer verbesserten Kompensation von Aufladungen bei der Sekundärionen-Massenspektrometrie elektrisch schlecht leitender Proben. Ein erfindungsgemäßes Verfahren sorgt dafür, daß zu jedem Zeitpunkt der Auftreffpunkt des Elektronenstrahles auf der Probe mit dem Auftreffpunkt des Ionenstrahles annähernd zusammenfällt.

Bei einem erfindungsgemäßen Verfahren und bei einer erfindungsgemäßen Vorrichtung wird eine solche Elektronenkanone verwendet, die eine Fokussierung des Elektronenstrahles auf annähernd denselben Durchmesser erlaubt, wie ihn der Ionenstrahl besitzt. Hierzu kann beispielsweise eine Elektronenkanone Verwendung finden, wie sie in herkömmlichen Geräten für die Auger-Elektronen-Spektrometrie eingesetzt wird.

Vorteilhafterweise wird der Elektronenstrahl synchron mit dem Ionenstrahl dadurch gerastert, daß die Ablenkspannungen sowohl für den Elektronenstrahl als auch für den Ionenstrahl von demselben Raster-Generator gemeinsam gesteuert werden. Lediglich die Verstärkung der Ausgangsspannungen des Raster-Generators auf die erforderlichen Ablenkspannungen für den Ionenstrahl und für den Elektronenstrahl erfolgt, wenn erforderlich, durch getrennte Gleichspannungsverstärker.

Durch überlagerbare Gleichspannungsanteile sowie durch die Möglichkeit der Abschwächung der Ausgangsspannungen des Raster-Generators, soweit sie zur Ablenkung des Elektronen-

0150326

strahles verwendet werden, wird eine etwa deckungsgleiche
Rasterung beider Strahlen ermöglicht.

Vorteile eines erfindungsgemäßen Verfahrens und einer erfindungsgemäßen Vorrichtung bestehen beispielsweise in der
Reproduzierbarkeit der Kompensation von Aufladungen bei der
Sekundärionen-Massenspektrometrie und damit auch in der Reproduzierbarkeit der Messungen, -in der schonenden Behandlung
der Probe und in der Vermeidung von lokalen Aufladungen
durch den Elektronenstrahl.

Die Erfindung wird anhand der Zeichnung näher erläutert.
Fig.1 zeigt das Prinzip einer Vorrichtung zur Kompensation
        elektrischer Aufladungen bei SIMS- Messungen nach dem
        Stand der Technik.
Fig.2 zeigt das Prinzip der Kompensation von Aufladungen bei
        einem Verfahren nach dem Stand der Technik.
Fig.3 zeigt das Prinzip der Kompensation von Aufladungen
        nach der Erfindung.
Fig.4 zeigt das Prinzip einer erfindungsgemäßen Vorrichtung
        zur Kompensation elektrischer Aufladungen bei SIMS-
        Messungen.

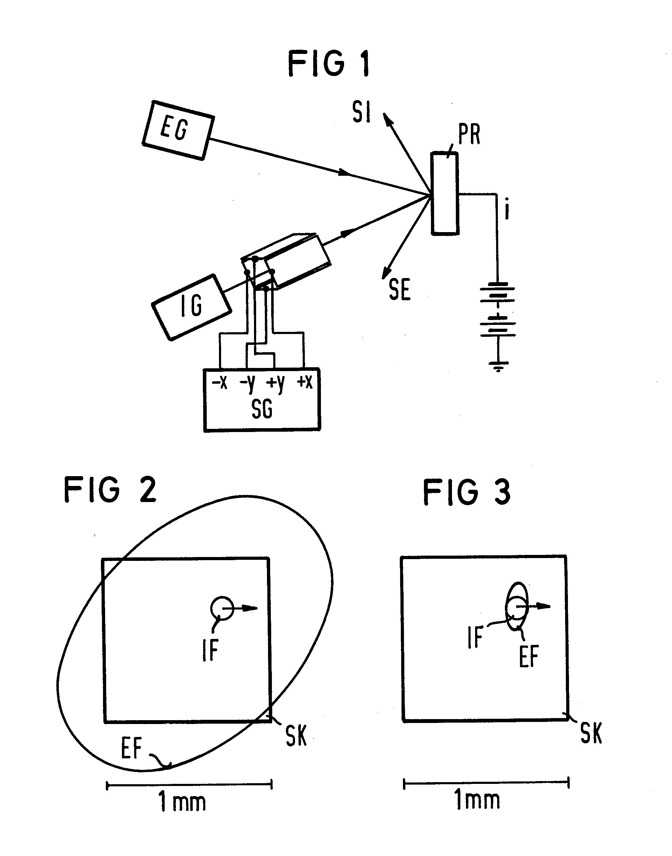

Fig.1 zeigt das Prinzip einer erfindungsgemäßen Vorrichtung
zur Kompensation elektrischer Aufladungen bei SIMS-Messungen nach dem Stand der Technik. Bei der Analysentechnik der
Sekundärionen-Massenspektrometrie (SIMS) wird in bekannter
Weise ein in einer Ionenkanone IG erzeugter Ionenstrahl zeilenweise über eine Probe PR gerastert und in dieser hierdurch
ein Sputterkrater erzeugt. Die dabei entstehenden ionenförmigen Abtragungsprodukte, nämlich die Sekundärionen SI, werden einem Massenspektrometer zugeführt und analysiert. Durch
die Registrierung der Signalintensität einer Ionenart in Abhängigkeit von der Zeit erhält man ein sogenanntes Tiefenprofil für das betreffende chemische Element bezüglich der Probe PR. Zur Signalintensität tragen dabei die Sekundärionen SI aus dem gesamten Kraterbereich bei. Als Raster-Ionenstrahlgerät kann beispielsweise ein Gerät a-DIDA der Fa. Atomika GmbH, München, Bundesrepublik Deutschland, verwendet werden.

Beim Auftreffen des Ionenstrahles auf die Probe PR werden u.a. Sekundärionen SI und Sekundärelektronen SE ausgelöst. Wenn die Probe PR eine schlechte Leitfähigkeit besitzt, wie dies beispielsweise bei Isolatoren - wie Oxiden, Nitriden, Gläsern und so weiter - der Fall ist, kann der sich aus dem Ionenstrahlstrom und aus den von der Probe PR emittierten, geladenen Sekundärionen SI und Sekundärelektronen SE sich ergebende Probenstrom i nur über den sehr hohen elektrischen Widerstand der Probe PR bzw. der Probenoberfläche abfließen. Hierdurch kommt es zu Aufladungen der Probe PR auf der vom Ionenstrahl getroffenen Fläche, die die Emission und/oder die Überführung der Sekundärionen SI in das Massenspektrometer beeinträchtigen oder gänzlich verhindern können.

Zur Kompensation elektrischer Aufladungen bei SIMS-Messungen wird nach dem Stand der Technik die Probe PR mit einem in einer Elektronenkanone EG erzeugten stehenden Elektronenstrahl beschossen, während der in der Ionenkanone IG erzeugte Ionenstrahl zeilenweise über die Probe PR gerastert wird. Das Abrastern der Probe PR mit Hilfe des Ionenstrahls wird dabei von einem Rastergenerator SG gesteuert. Zur Ablenkung des Ionenstrahls werden dabei von dem Ablenkgenerator SG an das Ablenkplattensystem DIG Signale in einer dem Fachmann bekannten Weise übermittelt. Das Ablenkplattensystem DIG besteht aus zwei Plattenpaaren zur Ablenkung in x-Richtung bzw. in y-Richtung.

Fig.2 zeigt das Prinzip der Kompensation von Aufladungen nach dem bekannten Stand der Technik. Besteht der Ionenstrahl aus positiv geladenen Ionen, so wird die Oberflächenaufladung ebenfalls positiv sein und kann daher durch gleichzeitigen Beschuß mit Elektronen aus einer Elektronenkanone EG prinzipiell kompensiert werden. Ein zu untersuuntersuchender Bereich auf der Oberfläche der Probe PR von etwa 1 mm x 1 mm ist in Fig.2 als Sputterkrater SK angegeben. Dieser Sputterkrater SK wird von einem Ionenstrahl zeilenweise abgerastert, dessen Brennfleck IF zeilenweise über den Sputterkrater SK wandert. Bei dem bekannten Verfahren zur Kompensation von Aufladungen nach dem Stand der Technik wird die Probe PR mit einem stehenden Elektronenstrahl beschossen. Der Durchmesser des Brennflecks EF des Elektronenstrahles beträgt bei diesem bekannten Verfahren etwa 1 mm und überdeckt somit die gesamte Fläche des Sputterkraters SK. Mit diesem bekannten Verfahren ist es zumeist möglich, Sekundärionen-Signale von Isolatoroberflächen zu registrieren. Die Tatsache, daß bei diesem bekannten Verfahren der Brennfleck EF des Elektronenstrahles praktisch ständig den gesamten Sputterkrater SK überdeckt und daß somit der Elektronenstrahl ständig auf den gesamten Sputterkrater SK einwirkt, während der viel kleinere Brennfleck IF des Ionenstrahles den gesamten Sputterkrater SK nur zeilenweise abrastert und somit Teilbereiche des Sputterkraters SK nur während eines Bruchteiles der gesamten Rasterzeit überdeckt, verursacht unzureichende Meßbedingungen und somit unzureichende Meßergebnisse.

Fig.3 zeigt das erfindungsgemäße Prinzip zur Kompensation von Aufladungen. Der Sputterkrater SK weist dieselben Abmessungen wie in Fig.2 auf. Der Auftreffpunkt EF des Elektronenstrahles auf der Probe PR fällt zu jedem Zeitpunkt mit dem Auftreffpunkt IF des Ionenstrahles annähernd zusammen.

Die Auftreffpunkte EF des Elektronenstrahles und IF des Ionenstrahles innerhalb des Sputterkraters SK rastern gemeinsam und gleichzeitig zeilenweise diesen Sputterkrater SK ab. Die Vorteile der Erfindung werden natürlich auch noch dann erzielt, wenn der Auftreffpunkt EF des Elektronenstrahles zeitlich und/oder räumlich ein klein wenig versetzt ist gegenüber dem Auftreffpunkt des Ionenstrahles IF. Von Bedeutung für ein erfindungsgemäßes Verfahren und für eine erfindungsgemäße Vorrichtung ist, daß der Elektronenstrahl und der Ionenstrahl gleichzeitig und stets mit annähernd gleichen Auftreffpunkten den Sputterkrater SK abrastern.

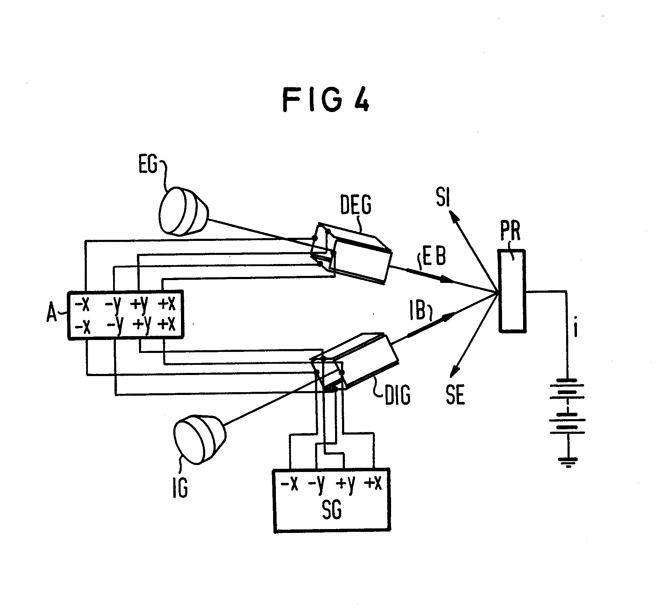

Fig.4 zeigt das Prinzip einer erfindungsgemäßen Vorrichtung zur Kompensation elektrischer Aufladungen bei SIMS-Messungen. Als Elektronenkanone EG kann beispielsweise eine Elektronenkanone verwendet werden, wie sie in kommerziell erhältlichen Scanning-Auger-Mikrosonden eingebaut ist. Vorteilhafterweise werden der Elektronenstrahl EB und der Ionenstrahl IB synchron dadurch gerastert, daß die Ablenkspannungen beider Strahlen EB, IB von demselben Raster-Generator SG gemeinsam gesteuert werden. Ein hierbei verwendbarer Raster-Generator SG ist in dem näher spezifizierten Gerät der Firma Atomika wie auch in jedem anderen SIMS-Gerät eingebaut. Da die Elektronenkanone EG und die Ionenkanone IG an verschiedenen Orten angeordnet sind, trifft im allgemeinen der Elektronenstrahl EB unter einem anderen Winkel auf die Probe PR auf, als dies für den Ionenstrahl IB der Fall ist. Um die Position des Elektronenstrahles EB zu justieren und um für den Unterschied der Auftreffwinkel von Ionenstrahl IB und Elektronenstrahl EB zu korrigieren, ist in einem Zusatzgerät (Verstärker) A die Möglichkeit gegeben, die Ausgangsspannungen des Raster-Generators SG einstellbar abzuschwächen. Dabei kann die x-Abschwächung verschieden von der y- Abschwächung sein, und diese Abschwä-

0150326
84 P 1058 E

chungen können zusätzlich in jeder Flächenkoordinate von der jeweilig anderen Koordinate abhängen. Zusätzlich können die Ausgangsspannungen des Gerätes A durch wählbare Gleichspannungen überlagert werden, um sicherzustellen, daß der Elektronenstrahl EB gemeinsam mit dem Ionenstrahl IB den Sputterkrater SK abrastert.

Zur Ablenkung des Elektronenstrahls EB werden dieselben Ablenksignale, die vom Ablenkgenerator (Raster-Generator) SG an das Ablenkplattensystem DIG des Ionenstrahls IB übermittelt werden, an die Eingänge des Zusatzgerätes (Verstärker) A angelegt. In diesem Zusatzgerät A können diese Ablenksignale des Raster-Generators SG einstellbar in der beschriebenen Weise abgeschwächt oder verstärkt werden. Die am Ausgang des Zusatzgerätes A anliegenden, in der Regel abgeschwächten bzw. verstärkten Ablenksignale des Raster-Generators SG werden sodann zur Ansteuerung eines weiteren Ablenkplattensystems DEG verwendet. Dieses zweite Ablenkplattensystem DEG dient zur Ablenkung des Elektronenstrahls EB und entspricht in seiner Funktionsweise dem Ablenkplattensystem DIG, das zur Ablenkung des Ionenstrahls IB dient. Die Modifikation der Ablenksignale des Raster-Generators SG im Zusatzgerät A und die Übermittlung dieser im Zusatzgerät A modifizierten Ablenksignale an das Ablenkplattensystem DEG bewirken, daß der Auftreffpunkt des Elektronenstrahls EB auf der Probe PR zu jedem Zeitpunkt mit dem Auftreffpunkt des Ionenstrahls IB auf der Probe PR annähernd zusammenfällt und daß die Auftreffpunkte des Elektronenstrahls EB und des Ionenstrahls IB innerhalb des Sputterkraters SK gemeinsam und gleichzeitig zeilenweise diesen Sputterkrater SK abrastern.

Um die Aufladungen möglichst gut und dauerhaft zu kompensieren, ist es vorteilhaft, die Elektronenstrahl-Stromstärke automatisch zu regeln. Bei dieser Regelung dient als Meßgröße entweder ein probentypisches Referenzsignal, wie z.B. ein Sekundärionen-Signal, oder der von der Probe PR über die Probenhalterung abfließende Probenstrom i. Dabei soll der Probenstrom-i so klein wie möglich werden und im Idealfall völlig verschwinden.

Patentansprüche:

1. Verfahren zur Kompensation von Aufladungen bei der Sekundärionen-Massenspektrometrie (SIMS) elektrisch schlecht leitender Proben (PR), mit einer Rasterionenkanone (IG) und einer Elektronenkanone (EG), dadurch g e k e n n z e i c h n e t , daß der Elektronenstrahl der Elektronenkanone (EG) auf ungefähr den gleichen Durchmesser fokussiert wird wie der Ionenstrahl, und daß der Elektronenstrahl auf demselben Punkt der Oberfläche der Probe (PR) auftrifft wie der Ionenstrahl.

2. Verfahren nach Anspruch 1, dadurch g e k e n n z e i c h n e t , daß der Elektronenstrahl und der Ionenstrahl synchron gerastert werden.

3. Verfahren nach Anspruch 2, dadurch g e k e n n z e i c h n e t , daß die Ablenkspannungen des Elektronenstrahles und des Ionenstrahles von demselben Raster-Generator (SG) gemeinsam gesteuert werden.

4. Verfahren nach einem der Ansprüche 1 bis 3, dadurch g e k e n n z e i c h n e t , daß der Elektronenstrahl und der Ionenstrahl durch überlagerbare Gleichspannungsanteile sowie durch die Möglichkeit der Abschwächung der Elektronenstrahl-Ablenkspannungen deckungsgleich gerastert werden.

5. Verfahren nach einem der Ansprüche 1 bis 4, dadurch g e k e n n z e i c h n e t , daß die Stromstärke des Elektronenstrahles automatisch geregelt wird.

6. Vorrichtung zur Kompensation von Aufladungen bei der Sekundärionen-Massenspektrometrie (SIMS) elektrisch schlecht leitender Proben (PR), mit einer Ionenkanone (IG) und einer

84 P 0150326 E

Elektronenkanone (EG), g e k e n n z e i c h n e t durch einen gemeinsamen Raster-Generator (SG) für Ionenkanone (IG) und Elektronenkanone (EG).

7. Vorrichtung nach Anspruch 6, g e k e n n z e i c h - n e t durch getrennte Gleichspannungsverstärker zur Erzeugung der Ablenkspannungen für die Ionenkanone (IG) und für die Elektronenkanone (EG) an den Ausgangsspannungen des Raster-Generators (SG).

8. Vorrichtung nach Anspruch 6 oder 7, g e k e n n - z e i c h n e t durch eine Einrichtung (A) zur Positionierung für den Elektronenstrahl und zur Korrektur für die unterschiedlichen Auftreffwinkel von Elektronenstrahl und Ionenstrahl auf die Probe (PR) durch einstellbare Ablenkspannungs-Abschwächungen sowie durch überlagerbare und wählbare Gleichspannungen.

0150326

1/2

FIG 1

FIG 2

FIG 3

# FIG 4